# FASCICULE DE BREVET EUROPEEN

(11) **EP 4 324 308 B1**
(45) Date de publication et mention de la délivrance du brevet: **29.01.2025**
(21) Numéro de dépôt: 22789276.7
(22) Date de dépôt: 21.09.2022
(51) Int. Cl.: H05K 3/36, H05K 7/14

(54) **CONNECTIQUE ÉLECTRONIQUE EMBARQUÉE DANS UN ENGIN SPATIAL**
ELEKTRONISCHE VERBINDER ZUR VERWENDUNG AN BORD EINES RAUMFAHRZEUGS
ELECTRONIC CONNECTORS FOR USE ON BOARD A SPACECRAFT

(30) Priorité: 23.09.2021 FR 2110034
(43) Date de publication de la demande: 21.02.2024
(73) Titulaire: Airbus Defence and Space SAS, 31402 Toulouse Cedex 4 (FR)
(72) Inventeur: GALIANA, Denis, 31402 Toulouse Cedex 4 (FR); AUDIN, Lionel, 31402 Toulouse Cedex 4 (FR); COUTANCE, Clément, 31402 Toulouse Cedex 4 (FR); MILLE-CHARNAY, Théo, 31320 Toulouse Cedex 4 (FR); GUEDON, Florent, 31402 Toulouse Cedex 4 (FR)
(74) Mandataire: Plasseraud IP
(86) Numéro de dépôt international: PCT/FR2022/051772
(87) Numéro de publication internationale: WO 2023/047052

(56) Documents cités:
- CN-U- 207 851 727
- DE-A1- 102010 045 884
- TW-A- 201 120 649
- US-A- 5 535 100
- US-A1- 2009 034 222
- US-A1- 2011 151 683
- US-A1- 2012 258 634
- US-A1- 2019 006 777
- US-B1- 6 302 700

## Description

### Domaine technique

La présente divulgation concerne une connectique embarquée dans un engin spatial équipé d'au moins une carte mère et de cartes filles.

### Technique antérieure

Dans le domaine spatial, chaque carte électronique est maintenue dans son boîtier, lequel est fixé à une structure régulée thermiquement de l'engin spatial. Lorsque l'on souhaite connecter des cartes électroniques entre elles, il arrive fréquemment d'être confronté à une problématique de défaut d'alignement des cartes, qui résulte de jeux sur les dimensions des cartes, sur l'emplacement des connecteurs, ou encore sur la planéité des cartes électroniques.

Les plaques de circuits imprimés ou PCB (« printed circuit board » en anglais) peuvent être montées sur des glissières, mais ces dernières limitent les surfaces d'échange thermique et donc le flux thermique maximum atteignable dans un environnement spatial. La masse des glissières est également un inconvénient de cette solution.

En variante, on peut par exemple utiliser des cartes formées d'un circuit-imprimé dit flexible, également désigné par « flex » en anglais, c'est-à-dire un circuit imprimé comprenant un support souple, par exemple formé d'un film de polyimide ou de PEEK, sur lequel sont agencées les pistes électriquement conductrices.

En alternative on peut également utiliser un circuit imprimé dit semi-flexible, également désigné par « semi-flex » en anglais, qui est composé d'un ensemble de plaques, typiquement réalisées en résine époxy, prolongées par des films par exemple en polyimide.

Ainsi, la présence de portions flexibles rend ces circuits imprimés plus complexes à fabriquer, donc plus coûteux, mais également plus fragiles. De plus dans un environnement spatial, l'évacuation thermique se fait principalement par les plaques époxy, qui sont placées en contact d'un support mécanique permettant d'évacuer la chaleur. La dissipation thermique dans un circuit imprimé semi-flexible est plus complexe à maîtriser car les capacités de dissipation thermique des films de support sont beaucoup plus limitées que la dissipation thermique offerte par les plaques époxy. Ceci est d'autant plus vrai dans le domaine spatial, où le refroidissement d'un composant électronique par convection n'est pas exploitable. Par conséquent, même pour les circuits imprimés dits semi-flexible, l'évacuation de la chaleur n'est correctement réalisée qu'au niveau des plaques époxy. En outre, le nombre de couches d'un circuit imprimé aménagé sur un film est limité, ce qui limite le nombre de signaux et la densité de courant admissibles par ces circuits. Le routage des signaux est également plus complexe du fait de l'impossibilité de réaliser un blindage électromagnétique sur les films de support.

Il est connu de US 2011/0151683 un ordinateur comprenant une carte mère et une carte d'extension où chaque carte comprend plusieurs connecteurs aptes à coopérer ensemble, et les connecteurs de la carte d'extension comprennent une languette ajourée.

Il est connu de DE102010045884 une carte mère qui est connectée à plusieurs cartes d'extension par l'intermédiaire d'une platine de connexion ; où chaque carte comprend une languette portant un connecteur venant s'enficher dans un connecteur respectif de la platine de connexion.

### Résumé

La présente divulgation vient améliorer la situation.

Il est proposé un dispositif électronique apte à être embarqué dans un engin spatial selon la revendication 1.

Dans des modes de réalisation, dans chaque carte fille, la languette est délimitée de part et d'autre de son premier connecteur par deux fentes s'étendant transversalement depuis un bord de sa plaque.

Dans des modes de réalisation, ladite plaque est réalisée en résine époxy, le plan principal du circuit imprimé de la carte mère étant disposé perpendiculairement aux plans principaux des circuits imprimés des cartes filles.

Dans des modes de réalisation, chaque premier connecteur comporte des organes de guidage disposés en ses deux extrémités réalisant un guidage par rapport à un des deuxièmes connecteurs.

Dans des modes de réalisation, chaque carte fille s'insère dans un boîtier métallique, les boitiers métalliques étant assemblés entre eux et fixés sur une structure porteuse de l'engin spatial, cette structure porteuse étant régulée en température par un système de régulation en température.

Dans des modes de réalisation, chaque carte fille est thermiquement reliée à son boîtier métallique par une interface thermique.

Dans des modes de réalisation, la carte mère est insérée dans un capot métallique, en étant thermiquement reliée au capot par une interface thermique.

Un autre objet de la présente est un engin spatial comprenant un dispositif électronique selon la description qui précède.

Un autre objet concerne un procédé d'assemblage d'un dispositif électronique selon la description qui précède, comprenant :
- une étape d'assemblage de cartes filles dans leurs boîtiers respectifs,
- une étape d'assemblage mécanique des boîtiers des cartes filles entre eux, et
- une étape de connexion électrique de chaque carte fille à ladite carte mère, ladite étape comprenant une déviation d'une languette d'au moins une des cartes filles supportant un premier connecteur coopérant avec des deuxièmes connecteurs de ladite carte mère pour s'adapter aux positionnements relatifs des cartes filles et de ladite carte mère, ledit premier connecteur électrique étant fixé à une plaque de support du circuit imprimé de ladite carte fille, lesdits deuxièmes connecteurs étant fixés à une plaque de support du circuit imprimé de ladite carte mère, ladite languette de ladite carte fille étant réalisée par une portion de sa plaque apte à être déviée par rapport à un plan principal de son circuit imprimé, et
- une étape d'assemblage d'un capot à la carte mère.

Dans des modes de réalisation, le procédé d'assemblage comprend en outre l'assemblage, à une structure porteuse régulée en température de l'engin spatial, des boitiers des cartes filles.

Avantageusement la conception d'ensembles électroniques comprenant chacun au moins une carte mère et des cartes filles est facilitée.

Un autre avantage réside dans l'amélioration de la régulation thermique dans les zones voisines des connexions entre carte mère et cartes filles.

Un avantage est encore que le dispositif électronique proposé permet d'utiliser des circuits imprimés aménagés sur des plaques époxy sans partie flexible, qui présentent des avantages en termes de coûts et d'approvisionnement. La présente invention exploite intelligemment la légère élasticité des plaques époxy pour permettre le rattrapage des jeux lors du montage.

Avantageusement encore, la souplesse de la languette portant le connecteur de la carte fille peut être augmentée par des évidements, ce qui permet par ailleurs de réduire l'effort supporté par chaque connecteur. L'extrémité de la languette, en avant des évidements, peut en outre rester pleine pour réduire encore les efforts supportés par les pins du connecteur.

Avantageusement encore, le rattrapage des jeux que permet l'invention ne se fait pas au détriment du poids de l'ensemble.

### Brève description des dessins

D'autres caractéristiques, détails et avantages apparaîtront à la lecture de la description détaillée ci-après, et à l'analyse des dessins annexés, sur lesquels :
**Fig. 1**

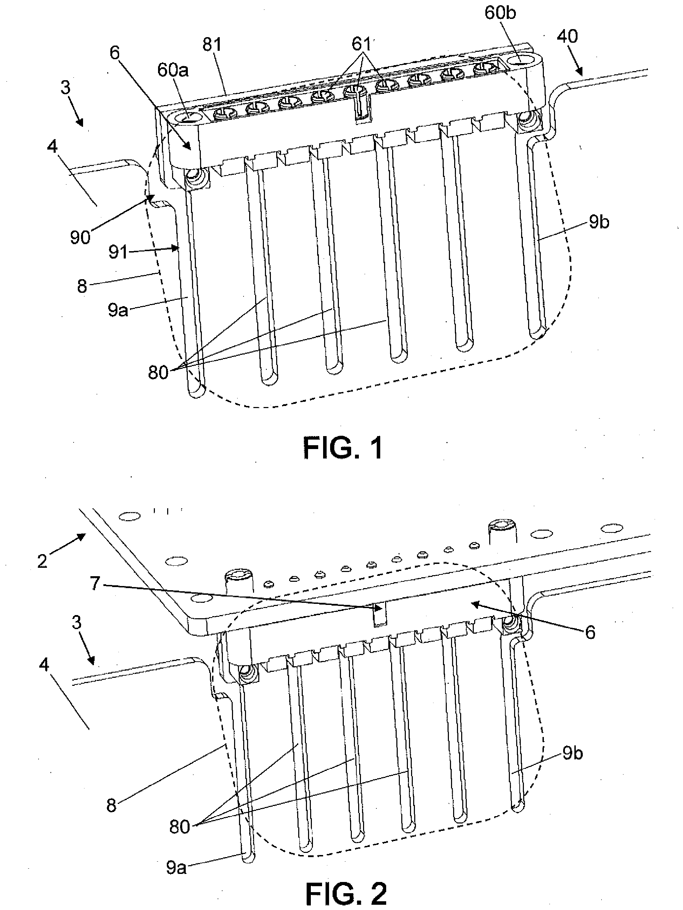

   [Fig. 1] montre une partie d'une carte fille selon l'invention.
**Fig. 2**
   [Fig. 2] représente une connexion entre une carte mère et une carte fille selon l'invention.
**Fig. 3**

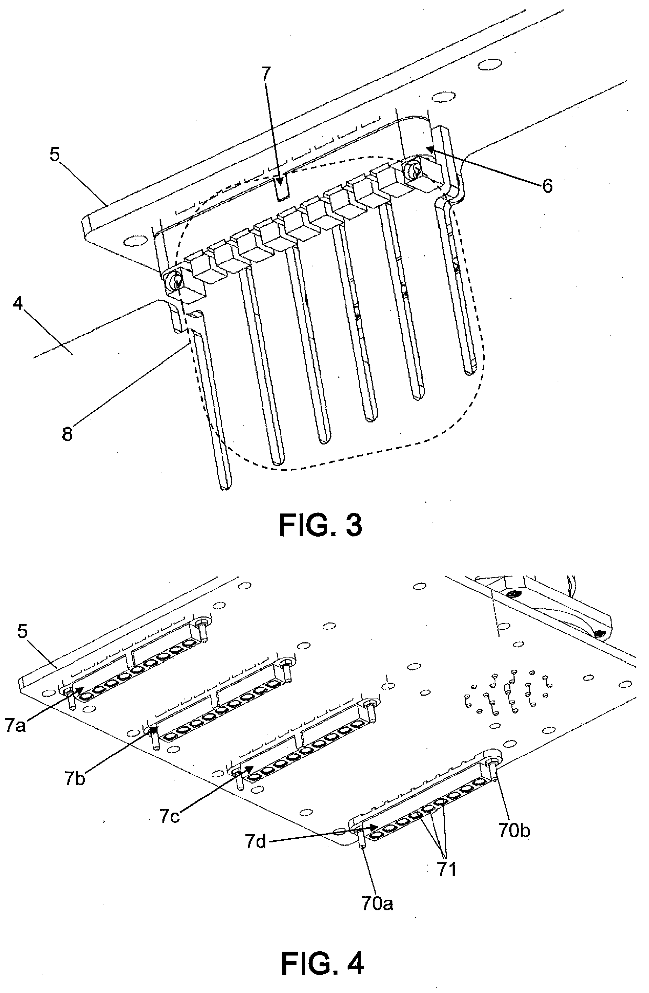

   [Fig. 3] représente la connexion selon l'invention représentée en [fig.2] selon une autre vue.
**Fig. 4**
   [Fig. 4] représente une carte mère comprenant une pluralité de connecteurs selon l'invention.
**Fig. 5**

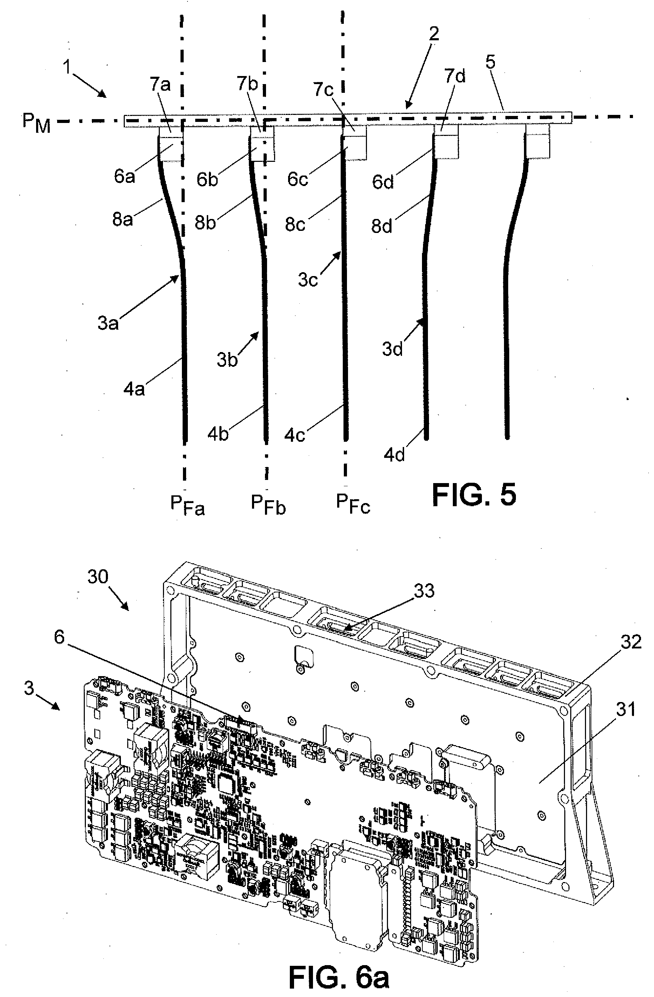

   [Fig. 5] représente schématiquement une connexion selon l'invention entre une carte mère et des cartes filles.
**Fig. 6a**
   [Fig. 6a] représente un exemple de boitier métallique de support d'une carte fille.
**Fig. 6b**

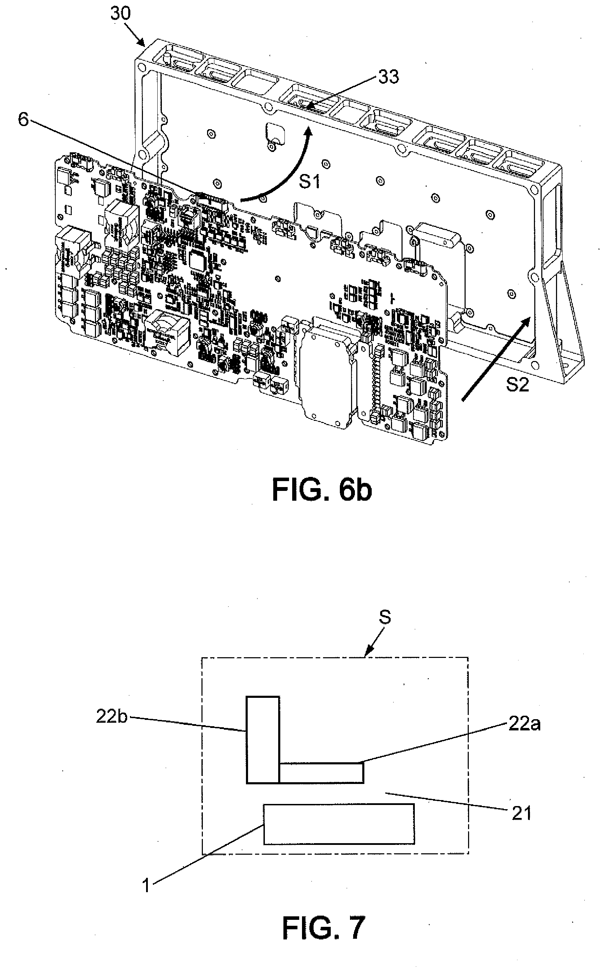

   [Fig. 6b] représente la cinématique d'insertion d'une carte fille dans son boîtier
**Fig. 7**
   [Fig. 7] représente schématiquement un engin spatial comprenant une structure porteuse régulée en température.
**Fig. 8**

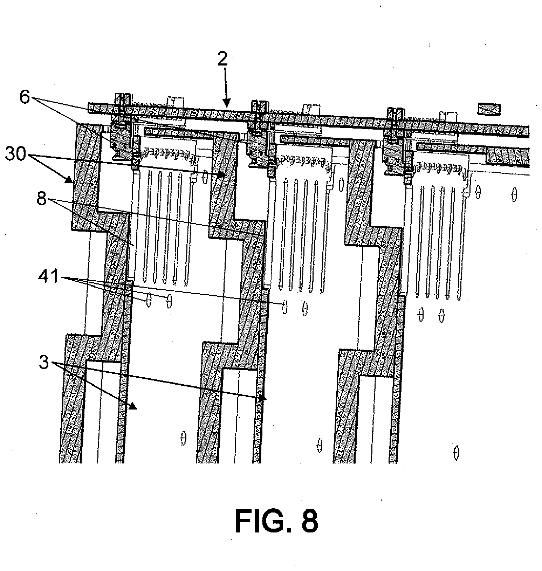

   [Fig. 8] représente un assemblage d'une carte mère avec une pluralité de cartes filles, les cartes filles étant contenues dans des boîtiers de support respectifs.
**Fig. 9a**

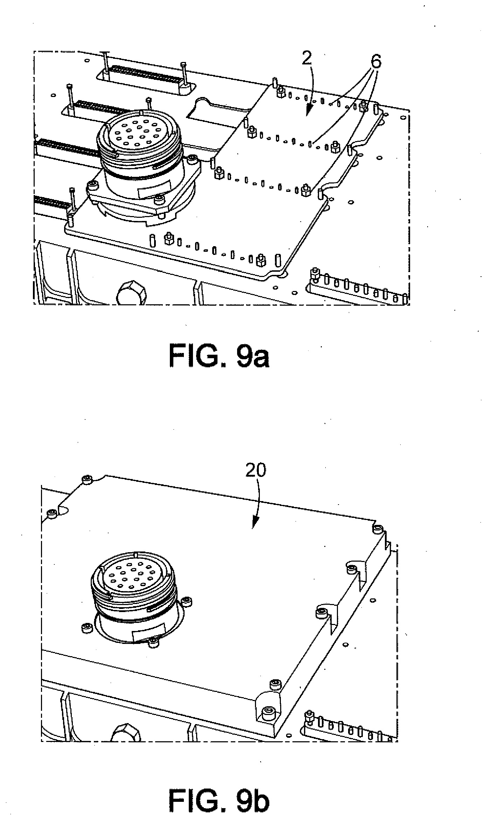

   [Fig. 9a] représente une carte mère assemblée à une pluralité de cartes filles contenues dans des boitiers de support respectifs.
**Fig. 9b**
   [Fig. 9b] représente l'assemblage de la figure 9a après avoir assemblé un capot sur la carte mère.

### Description des modes de réalisation

En référence aux figures 1 à 5, on va maintenant décrire un dispositif électronique 1 apte à être embarqué dans un engin spatial, comprenant au moins une carte mère 2 une pluralité de cartes filles 3 reliées électriquement à la carte mère.

Chacune de la carte mère 2 et des cartes filles 3 est une carte électronique comprenant une plaque de support 4, 5 sensiblement plane. Chaque plaque de support 4,5 peut former le support d'un circuit imprimé de type rigide ou PCB pour « Printed Circuit Board » en anglais, et être formée en un matériau électriquement isolant, par exemple en résine epoxy. On peut, par exemple, utiliser un PCB du type FR4 ou polyimide. Sur chaque plaque peuvent être agencées un ensemble de pistes électriquement conductrices (non représentées) ainsi que des emplacements et des connecteurs (non représentés) permettant de monter des composants électroniques sur chaque carte et de les connecter entre eux. Dans la présente invention on viendra déformer les PCB de cartes filles tout en restant dans les tolérances données par le fabricant pour préserver la fiabilité du PCB.

De plus, chaque carte fille 3 comprend un connecteur 6 fixé à sa plaque 4, et la carte mère comprend une pluralité de connecteurs référencés 7a, 7b, 7c et 7d fixés à la plaque 5 de la carte mère, chaque connecteur 7 de la carte mère étant adapté pour coopérer mécaniquement et électriquement avec le connecteur référencé 6a, 6b, 6c ou 6d d'une carte fille respective référencé 3a, 3b, 3c ou 3d afin de connecter chaque carte fille à la carte mère. Chaque connecteur 6, 7 peut être fixé à sa plaque respective par exemple par vissage.

Chaque connecteur 6,7 peut comprendre des organes de guidage mécanique 60, 70 et des contacts électriques 61, 71. Dans des modes de réalisation, les connecteurs s'étendent selon une direction principale, les organes de guidage mécanique et les contacts électriques étant alignés selon cette direction principale. Chaque connecteur peut comprendre deux organes de guidage mécanique 60a, 60b, 70a, 70b aux deux extrémités selon cette direction principale, les contacts électriques 61, 71 étant disposés entre les organes de guidage mécanique. C'est le cas dans l'exemple représenté sur les figures, où les connecteurs des cartes filles comprennent des organes de guidage femelle pouvant recevoir des organes de guidage mâle complémentaire des connecteurs de la carte mère. Bien entendu cet exemple n'est nullement limitatif et le cas inverse peut également être envisagé. On pourrait également avoir des connecteurs sans guides mécaniques.

En référence à la figure 4, des connecteurs 7a, 7b, 7c et 7d identiques de la carte mère sont dédiés à la connexion avec des connecteurs des cartes filles respectives 3a, 3b 3c et 3d. Chaque connecteur de chaque carte fille est par exemple identique. Les connecteurs de la carte mère avantageusement identiques sont montés sur une même face de la plaque de support 5 de la carte mère. Ces connecteurs 7a, 7b, 7c et 7d sont de plus alignés parallèlement les uns aux autres de manière à pouvoir connecter plusieurs cartes filles à la carte mère, de sorte que les cartes filles s'étendent parallèlement les unes aux autres.

Comme représenté aux figures 3 et 5, les connecteurs 6,7 de la carte mère et des cartes filles sont conformés pour permettre une connexion entre la carte mère et les cartes filles de sorte que le plan PM de la plaque de support 5 de la carte mère 2 soit perpendiculaire aux plans PFa, PFb, PFc des plaques de support 4a, 4b, 4c des cartes filles 3a, 3b, 3c. La figure 5 représente notamment chaque languette et, dans son prolongement, le plan principal de chaque carte fille. Les connecteurs réalisent ainsi une connexion perpendiculairement à la carte mère, puis deux déviations en sens opposés pour rejoindre le plan principal, également perpendiculaire à la carte mère. A cet égard, les connecteurs de la carte mère ou des cartes filles peuvent être des connecteurs coudés à angle droit, c'est-à-dire dont les broches de connexion s'étendent parallèlement à la plaque sur laquelle le connecteur est monté, tandis que les autres connecteurs sont des connecteurs droits, c'est-à-dire dont les broches de connexion s'étendent perpendiculairement à la plaque sur laquelle le connecteur est monté.

Afin de pouvoir connecter plusieurs cartes filles 3 à la carte mère 2 tout en s'affranchissant des problématiques liés aux jeux sur les dimensions des composants, les positionnements des composants ou encore la planéité des PCB, la plaque 4 de chaque carte fille 3 comporte une portion formant une languette 8 apte à être déviée par rapport au plan principal de la plaque support 4 de la carte, cette portion portant le connecteur 6 de la carte fille. En référence à la figure 1, la languette 8 peut être délimitée de part et d'autre du connecteur par deux fentes 9a, 9b s'étendant transversalement depuis un bord 40 de la plaque, le connecteur 6 étant lui-même monté sur la plaque entre les fentes, et de préférence au voisinage de ce bord. De cette façon, en référence à la figure 5, il est possible de compenser certains jeux ou désalignements en conférant à cette portion de la plaque une légère élasticité permettant de fléchir la languette 8 sur laquelle est monté le connecteur 6. Ainsi, et comme représenté de façon schématique sur la figure 5, au moment de l'assemblage du dispositif électronique, comprenant la connexion de plusieurs cartes filles 3a à 3d à la carte mère 2, il est possible de positionner chaque carte fille relativement à la carte mère, et de dévier la languette 8a à 8d portant le connecteur 6a à 6d de chaque carte fille 3a à 3d afin de le connecter à un connecteur respectif 7a à 7d d'une carte mère.

Les deux fentes 9a, 9b délimitant la languette 8 latéralement sont avantageusement dimensionnées en fonction de la déviation souhaitée de la languette 8 par rapport au plan de la plaque. Elles peuvent par exemple présenter une longueur comprise entre 1 et 5 cm, cette longueur étant mesurée du bord de la plaque jusqu'à l'extrémité de chaque fente. Selon un exemple non limitatif, les deux fentes peuvent présenter une longueur de 3 cm pour rattraper un décalage de 400µm entre un connecteur électrique porté par la carte mère et le connecteur correspondant de la carte fille.

Dans des modes de réalisation, la languette 8, c'est-à-dire la portion de la carte comprise entre les fentes latérales 9a, 9, peut être plus longue que les portions de la plaque situées à l'extérieur des fentes, de manière à avoir une languette saillante par rapport au bord de la plaque, ce qui peut permettre une plus grande facilité d'assemblage et de manipulation des connecteurs.

Les deux fentes 9a, 9b s'étendant de part et d'autre du connecteur peuvent s'étendre perpendiculairement au bord 40 de la plaque 4. Dans un mode de réalisation, les deux fentes 9 peuvent comprendre une première portion 90 coudée s'étendant à partir du bord de la plaque et contournant les extrémités latérales du connecteur, et une portion d'extrémité rectiligne 91, s'étendant par exemple perpendiculairement au bord de la plaque. De cette façon, la languette présente une largeur, entre les extrémités latérales des deux fentes, qui est inférieure à la largeur du connecteur, ce qui confère une plus grande flexibilité à la languette. La largeur moyenne de la languette peut notamment être réduite grâce aux deux décrochements 90 au niveau du bord de la carte fille. La base de la languette présente alors une première largeur se prolongeant jusqu'à une partie élargie de la languette sur laquelle est fixée son connecteur. Dans l'exemple non limitatif représenté en figure 1, le connecteur comprend à ses deux extrémités deux organes de guidage 60a, 60b, et chaque fente comprend une portion d'extrémité 91 alignée avec chaque organe de guidage du connecteur et une portion coudée 90 reliant la portion d'extrémité au bord de la plaque formant ainsi un décrochement.

Dans des modes de réalisation, la languette 8 comprend également un ou plusieurs évidements 80 d'assouplissement de la languette disposés dans une partie médiane de la languette. Ces évidements peuvent être traversants ou non.

Chaque languette 8 comprend par exemple une pluralité d'évidements 80 traversants et rectilignes s'étendant parallèlement les uns aux autres et, le cas échéant, parallèlement aux fentes délimitant la languette. La languette peut néanmoins comprendre, à son extrémité située du côté du bord de la plaque, une partie pleine 81 d'appui du connecteur. Dans ce cas, les évidements d'assouplissement 80 de la languette 8 peuvent s'étendre depuis la portion pleine 81 jusqu'au niveau des extrémités des fentes 9a et 9b.

Le fait de conserver une portion pleine 81 d'appui du connecteur permet de limiter les contraintes en arrachement appliquées aux broches électriquement conductrices du connecteur aménagées dans cette partie pleine 81.

Chaque carte fille 3 peut être insérée dans un boitier métallique respectif 30, chaque carte pouvant être thermiquement reliée à son boîtier respectif par une interface thermique (non représentée). En référence à la figure 6a, on a représenté une carte fille et son boîtier de support 30, également appelé cuvette. Le boîtier 30 de chaque carte fille est conformé pour permettre une déviation de la languette. En particulier, la languette 8 n'est pas fixée au boîtier par une interface thermique. La chaleur générée sur la carte est évacuée à travers le PCB dans le cadre métallique. Sur la figure 6b, on a représenté la cinématique d'insertion de la carte fille 3 dans le boîtier 30. Le boîtier peut notamment comprendre une paroi de fond 31 et un rebord périphérique 32 délimitant une cavité ouverte dans laquelle la carte peut être insérée. Le boîtier 30 comprend un orifice traversant 33 agencé dans le rebord périphérique 32 et dimensionné pour permettre l'insertion du connecteur 6 porté par la languette 8 d'une carte fille au travers de l'orifice. Dans une première étape S1, la carte fille est donc insérée dans le boîtier dans une position inclinée par rapport au plan de la paroi de fond du boîtier, en insérant le connecteur porté par la languette 8 au travers de l'orifice 33, puis elle est rabattue S2 pour s'étendre parallèlement au plan de la paroi de fond du boîtier. Elle peut ensuite être assemblée mécaniquement au boîtier 30, par exemple par vissage. En référence à la figure 8, la plaque 4 d'une carte fille peut comprendre des alésages 41 permettant de visser la carte fille à la paroi de fond du boîtier. Ainsi, chaque carte fille est rigidement assemblée à son boîtier mais la languette 8 reste mobile par rapport au plan de chaque plaque, en étant libre de dévier légèrement au travers de l'orifice traversant 33 de chaque boîtier. Cela permet d'assembler les cartes filles à la carte mère en déviant légèrement la languette portant le connecteur d'une ou plusieurs cartes filles pour correspondre à l'alignement des connecteurs de la carte mère. Ainsi les erreurs de positionnements des connecteurs des cartes filles par rapport au connecteur de la carte mère peuvent être compensées.

Une fois chaque carte fille assemblée à son boitier, les boitiers sont assemblés rigidement entre eux.

En référence aux figures 8 et 9a, la carte mère est ensuite assemblée aux cartes filles, en connectant chaque connecteur de la carte mère à un connecteur respectif d'une carte fille, ledit connecteur étant au besoin dévié.

En référence à la figure 9b, la carte mère 2 est assemblée à un capot 20 pouvant se présenter sous la forme d'une paroi de fond munie d'un rebord périphérique et formant ainsi une cavité ouverte, cette cavité ouverte étant orientée, lors de l'assemblage de la carte même aux cartes filles, vers les cartes filles.

En référence à la figure 7, lorsque le dispositif électronique 1 est embarqué dans un engin spatial S, chaque boîtier 30 d'une carte fille peut lui-même être fixé sur une structure porteuse 21 de l'engin spatial qui peut être régulée en température par un système de régulation thermique, comprenant par exemple une structure de transfert de chaleur comprenant un évaporateur 22a relié à une source chaude, en l'occurrence le dispositif électronique 1 par l'intermédiaire de la structure porteuse 21, et un radiateur 22b situé à l'extérieur de l'engin spatial S de façon à évacuer la chaleur vers l'espace.

Ainsi, selon un mode de réalisation, un procédé d'assemblage d'un dispositif électronique selon la description qui précède peut comprendre en outre la fixation des boitiers des cartes filles et/ou du capot de la carte mère sur la structure porteuse 21 de l'engin spatial, cette structure porteuse étant régulée en température par un système de régulation en température 22.

## Revendications

1. Dispositif électronique (1) apte à être embarqué dans un engin spatial, comprenant au moins une carte mère (2) reliée électriquement à des cartes filles (3a, 3b, 3c), ladite carte mère (2) et lesdites cartes filles (3) comprenant chacune une plaque (4a, 4b, 4c, 5) de support pour constituer un circuit imprimé, chaque plaque s'étendant selon un plan principal respectif, chaque carte fille (3a, 3b, 3c) comprenant au moins un premier connecteur électrique (6a, 6b, 6c, 6d) fixé à sa plaque et la carte mère comprenant un nombre correspondant de deuxièmes connecteurs (7a, 7b, 7c, 7d) fixés à la plaque de la carte mère, chaque premier connecteur (6a, 6b, 6c, 6d) coopérant avec un des deuxièmes connecteurs (7a, 7b, 7c, 7d), **caractérisé en ce que** ledit premier connecteur (6a, 6b, 6c, 6d) de chaque carte fille est disposé sur une portion de la plaque formant une languette (8) apte à être déviée par rapport au plan principal du circuit imprimé, chaque languette (8) comportant à son extrémité une partie pleine (81) d'appui du premier connecteur et comprenant en outre des évidements (80) d'assouplissement de la languette.

2. Dispositif électronique selon la revendication 1, où dans chaque carte fille, la languette (8) est délimitée de part et d'autre de son premier connecteur par deux fentes (9a, 9b) s'étendant transversalement depuis un bord (40) de sa plaque.

3. Dispositif électronique selon l'une des revendications précédentes, dans lequel ladite plaque est réalisée en résine époxy, le plan principal du circuit imprimé de la carte mère étant disposé perpendiculairement aux plans principaux des circuits imprimés des cartes filles.

4. Dispositif électronique selon l'une des revendications précédentes, dans lequel chaque premier connecteur (6a) comporte des organes de guidage (110) disposés en ses deux extrémités réalisant un guidage par rapport à un des deuxièmes connecteurs.

5. Dispositif électronique selon l'une des revendications précédentes, où chaque carte fille (3) s'insère dans un boîtier métallique (30), les boîtiers métalliques (30) étant assemblés entre eux et fixés sur une structure porteuse (21) de l'engin spatial, cette structure porteuse étant régulée en température par un système de régulation en température (22).

6. Dispositif électronique selon la revendication précédente où chaque carte fille est thermiquement reliée à son boîtier métallique (30) par une interface thermique.

7. Dispositif électronique selon l'une des revendications précédentes, où la carte mère (2) est insérée dans un capot métallique (20), en étant thermiquement reliée au capot par une interface thermique.

8. Engin spatial comprenant un dispositif électronique selon l'une des revendications 1 à 7.

9. Procédé d'assemblage d'un dispositif électronique selon l'une des revendications 1 à 7, comprenant :
- une étape d'assemblage de cartes filles (3) dans leurs boîtiers respectifs (30),
- une étape d'assemblage mécanique des boîtiers (30) des cartes filles (3) entre eux,
- une étape de connexion électrique de chaque carte fille (3) à ladite carte mère (2), ladite étape étant comprenant une déviation d'une languette (8) d'au moins une des cartes filles (3) supportant un premier connecteur (6a, 6b, 6c, 6d) coopérant avec des deuxièmes connecteurs (7a, 7b, 7c) de ladite carte mère pour s'adapter aux positionnements relatifs des cartes filles et de ladite carte mère, ledit premier connecteur électrique (6a, 6b, 6c) étant fixé à une plaque de support du circuit imprimé de ladite carte fille, lesdits deuxièmes connecteurs (7a, 7b, 7c) étant fixés à une plaque de support du circuit imprimé de ladite carte mère, ladite languette de ladite carte fille étant réalisée par une portion de sa plaque apte à être déviée par rapport à un plan principal de son circuit imprimé, et
- une étape d'assemblage d'un capot (20) à la carte mère.

10. Procédé d'assemblage d'un dispositif électronique selon la revendication précédente, comprenant en outre l'assemblage, à une structure porteuse (21) régulée en température de l'engin spatial, des boîtiers des cartes filles.

## Patentansprüche

1. Elektronische Vorrichtung (1) zur Verwendung an Bord eines Raumfahrzeugs, aufweisend mindestens eine Mutterkarte (2), die elektrisch mit Tochterkarten (3a, 3b, 3c) verbunden ist, wobei die Mutterkarte (2) und die Tochterkarten (3) jeweils eine Trägerplatte (4a, 4b, 4c, 5) aufweisen, um eine gedruckte Schaltung zu bilden, wobei jede Platte sich in einer jeweiligen Hauptebene erstreckt, jede Tochterkarte (3a, 3b, 3c) mindestens einen ersten elektrischen Verbinder (6a, 6b, 6c, 6d), der an ihrer Platte befestigt ist, aufweist und die Mutterkarte eine entsprechende Anzahl von zweiten Verbindern (7a, 7b, 7c, 7d), die an der Platte der Mutterkarte befestigt sind, aufweist, wobei jeder erste Verbinder (6a, 6b, 6c, 6d) mit einem der zweiten Verbinder (7a, 7b, 7c, 7d) zusammenwirkt, **dadurch gekennzeichnet, dass** der erste Verbinder (6a, 6b, 6c, 6d) jeder Tochterkarte an einem Abschnitt der Platte angeordnet ist, der eine Zunge (8) bildet, die bezüglich der Hauptebene der gedruckten Schaltung biegbar ist, wobei jede Zunge (8) an ihrem Ende einen massiven Teil (81) zum Halten des ersten Verbinders aufweist und ferner Aussparungen (80), um der Zunge Biegsamkeit zu verleihen, aufweist.

2. Elektronische Vorrichtung nach Anspruch 1, wobei in jeder Tochterkarte die Zunge (8) beiderseits ihres ersten Verbinders von zwei Schlitzen (9a, 9b) begrenzt ist, die sich von einem Rand (40) ihrer Platte aus transversal erstrecken.

3. Elektronische Vorrichtung nach einem der vorstehenden Ansprüche, in welcher die Platte aus einem Epoxidharz hergestellt ist, wobei die Hauptebene der gedruckten Schaltung der Mutterkarte senkrecht zu den Hauptebenen der gedruckten Schaltungen der Tochterkarten angeordnet ist.

4. Elektronische Vorrichtung nach einem der vorstehenden Ansprüche, in welcher jeder erste Verbinder (6a) an seinen beiden Enden angeordnete Führungselemente (110) aufweist, die eine Führung bezüglich eines der zweiten Verbinder bereitstellen.

5. Elektronische Vorrichtung nach einem der vorstehenden Ansprüche, wobei jede Tochterkarte (3) in einem metallischen Gehäuse (30) einsetzbar ist, die metallischen Gehäuse (30) zusammengefügt sind und an einer tragenden Struktur (21) des Raumfahrzeugs befestigt sind, wobei diese tragende Struktur von einem Temperaturregulierungssystem (22) temperaturgeregelt wird.

6. Elektronische Vorrichtung nach dem vorstehenden Anspruch, wobei jede Tochterkarte via eine thermische Schnittstelle thermisch mit ihrem metallischen Gehäuse (30) verbunden ist.

7. Elektronische Vorrichtung nach einem der vorstehenden Ansprüche, wobei die Mutterkarte (2) in einer metallischen Kappe (20) eingesetzt ist und dabei via eine thermische Schnittstelle thermisch mit der Kappe verbunden ist.

8. Raumfahrzeug aufweisend eine elektronische Vorrichtung nach einem der Ansprüche 1 bis 7.

9. Verfahren zum Zusammenbauen einer elektronischen Vorrichtung nach einem der Ansprüche 1 bis 7, aufweisend:
- einen Schritt zum Einsetzen von Tochterkarten (3) in ihre jeweiligen Gehäuse (30),
- einen Schritt zum mechanischen Zusammenfügen der Gehäuse (30) der Tochterkarten (3) untereinander,
- einen Schritt zum elektrischen Anschließen jeder Tochterkarte (3) an die Mutterkarte (2), wobei der Schritt ein Biegen einer Zunge (8) mindestens einer der Tochterkarten (3) aufweist, die einen ersten Verbinder (6a, 6b, 6c, 6d) trägt, der mit zweiten Verbindern (7a, 7b, 7c) der Mutterkarte zusammenwirkt, um sich an relative Positionierungen der Tochterkarten und der Mutterkarte anzupassen, wobei der erste elektrische Verbinder (6a, 6b, 6c) an einer Trägerplatte der gedruckten Schaltung der Tochterkarte befestigt ist, die zweiten Verbinder (7a, 7b, 7c) an einer Trägerplatte der gedruckten Schaltung der Mutterkarte befestigt sind, die Zunge der Tochterkarte aus einem Abschnitt ihrer Platte besteht, der bezüglich einer Hauptebene ihrer gedruckten Schaltung biegbar ist, und
- einen Schritt eines Anbringens einer Kappe (20) an der Mutterkarte.

10. Verfahren zum Zusammenbauen einer elektronischen Vorrichtung nach dem vorstehenden Anspruch, aufweisend ferner das Anbringen der Gehäuse der Tochterkarten an einer temperaturgeregelten tragenden Struktur (21) des Raumfahrzeugs.

## Claims

1. Electronic device (1) suitable for use on board a spacecraft, comprising at least one motherboard (2) electrically connected to daughterboards (3a, 3b, 3c), said motherboard (2) and said daughterboards (3) each comprising a support plate (4a, 4b, 4c, 5) in order to form a printed circuit board, each plate extending in a respective main plane, each daughterboard (3a, 3b, 3c) comprises at least one first electrical connector (6a, 6b, 6c, 6d) fixed to its plate and the motherboard comprises a corresponding number of second connectors (7a, 7b, 7c, 7d) fixed to the plate of the motherboard, each first connector (6a, 6b, 6c, 6d) engaging with one of the second connectors (7a, 7b, 7c, 7d), **characterized in that** said first connector (6a, 6b, 6c, 6d) of each daughterboard being arranged on a portion of the plate forming a tab (8) capable of deflection relative to the main plane of the printed circuit board, each tab (8) having at its end a solid portion (81) supporting said first connector and further comprising cavities (80) for increasing the flexibility of the tab.

2. Electronic device according to claim 1, wherein, in each daughterboard, the tab (8) is delimited on either side of its first connector by two slots (9a, 9b) extending transversely from an edge (40) of its plate.

3. Electronic device according to one of the preceding claims, wherein said plate is made of epoxy resin, the main plane of the printed circuit board of the motherboard being arranged perpendicularly to the main planes of the printed circuit boards of the daughterboards.

4. Electronic device according to one of the preceding claims, wherein each first connector (6a) comprises guide members (110) arranged at its two ends, providing guidance relative to one of the second connectors.

5. Electronic device according to one of the preceding claims, wherein each daughterboard (3) is inserted into a metal housing (30), the metal housings (30) being assembled together and fixed to a supporting structure (21) of the spacecraft, this supporting structure being temperature-regulated by a temperature regulation system (22).

6. Electronic device according to the preceding claim, wherein each daughterboard is thermally connected to its metal housing (30) via a thermal interface.

7. Electronic device according to one of the preceding claims, wherein the motherboard (2) is inserted into a metal cover (20), being thermally connected to the cover by a thermal interface.

8. Spacecraft comprising an electronic device according to one of claims 1 to 7.

9. Method for assembling an electronic device according to one of claims 1 to 7, comprising:
- a step of assembling daughterboards (3) in their respective housings (30),
- a step of mechanically assembling together the housings (30) of the daughterboards (3),
- a step of electrically connecting each daughterboard (3) to said motherboard (2), said step comprising a deflection of a tab (8) of at least one of the daughterboards (3), said tab supporting a first connector (6a, 6b, 6c, 6d) which can engage with second connectors (7a, 7b, 7c) of said motherboard, in order to adapt to the relative positions of the daughterboards and of said motherboard, said first electrical connector (6a, 6b, 6c) being fixed to a support plate of the printed circuit board of said daughterboard, said second connectors (7a, 7b, 7c) being fixed to a support plate of the printed circuit board of said motherboard, said tab of said daughterboard being created by a portion of its plate capable of deflection relative to a main plane of its printed circuit board, and
- a step of assembling a cover (20) to the motherboard.

10. Method for assembling an electronic device according to the preceding claim, further comprising the assembling of the housings of the daughterboards to a temperature-regulated supporting structure (21) of the spacecraft.
